# EUROPÄISCHE PATENTSCHRIFT

(11) **EP 1 801 602 B1**
(45) Veröffentlichungstag und Bekanntmachung des Hinweises auf die Patenterteilung: **06.04.2011**
(21) Anmeldenummer: 05028111.2
(22) Anmeldetag: 21.12.2005
(51) Int. Cl.: G01R 31/28, B07C 5/344, H05K 13/02

(54) **Vorrichtung und Verfahren zum Positionieren von elektronischen Mikrochips zum elektrischen Testen**
Device and process for positionning electronic microchips to be electrically tested
Dispositif et procédé de positionnement de micropuces électroniques à tester électriquement

(43) Veröffentlichungstag der Anmeldung: 27.06.2007
(73) Patentinhaber: Rasco GmbH, 83059 Kolbermoor (DE)
(72) Erfinder: Arnold, Johann, 83109 Großkarolinenfeld (DE)
(74) Vertreter: Grünecker, Kinkeldey, Stockmair & Schwanhäusser Anwaltssozietät

(56) Entgegenhaltungen:
- GB-A- 1 125 229
- US-A- 3 727 757
- US-A- 3 896 935
- US-A- 4 000 798
- US-A- 4 889 242
- US-A- 5 184 068
- US-A- 5 348 164
- US-A1- 2005 099 174

## Beschreibung

Nach dem Herstellen von elektrischen Mikrochips werden diese in der Regel elektrisch getestet. Dies beinhaltet auch ein Testen bei verschiedenen Temperaturen, da für Mikrochips in der Regel gewisse Temperaturanforderungen gegeben sein müssen. Hierzu sind Vorrichtungen bekannt, bei denen Mikrochips auf die gewünschte Temperatur (auch Raumtemperatur) gebracht und dann entsprechend positioniert werden, um sie einer elektrischen Testeinrichtung zuzuführen.

Die US 3,727,757 offenbart eine DIP Handhabungsvorrichtung.

Die GB 1,125,229 offenbart Verbesserungen in Bezug auf eine Testvorrichtung für elektrische Komponenten.

Aufgabe der vorliegenden Erfindung ist es, eine Vorrichtung und ein Verfahren zum Positionieren von elektrischen Mikrochips zum elektrischen Testen anzugeben, mit dem eine möglichst hohe Durchsatzrate erreicht werden kann und gleichzeitig sichergestellt wird, dass möglichst wenig Fehler (Fehlpositionierungen, Verklemmungen von Mikrochips etc.) auftreten.

Diese Aufgabe wird gelöst mit einer Vorrichtung nach Anspruch 1 und einem Verfahren nach Anspruch 11 und/oder 19. Vorteilhafte Ausführungsformen sind in den Unteransprüchen offenbart.

Bei der Vorrichtung ist ein Transportweg für die Mikrochips vorgesehen. Mit der Vorrichtung können eine große Anzahl von Mikrochips entlang des Transportwegs transportiert werden. Der Transportweg umfasst eine Messposition. In dieser Position müssen die Mikrochips möglichst genau und wohldefiniert positioniert sein, um elektrisch kontaktiert und dann getestet werden zu können. Hierzu ist in der Regel ein Messstopper vorgesehen, mit dem ein Mikrochip entlang des Transportweges in der Messposition gestoppt werden kann. Der Messstopper legt somit die Messposition fest.

Weiterhin weist die Vorrichtung einen Vorstopper auf, mit der ein Mikrochip oberhalb der Messposition gehalten werden kann. In dieser Position wird der Mikrochip gehalten, um dann dem Messstopper und damit der Messposition möglichst zügig zugeführt werden zu können.

Weiterhin ist ein Zwischenstopper vorgesehen, mit dem ein Mikrochip in einer Position zwischen der Messposition und der Vorstopperposition gehalten werden kann.

Der Zwischenstopper ist hierbei jedoch soweit von der Position, die durch den Messstopper vorgegeben wird, entfernt, dass der Zwischenstopper stromauf der stromauf weisenden Kante (bei Transport von oben nach unten also stromauf von der Oberkante) eines Mikrochips in der Messposition in den Transportweg eingreift. Dadurch ist es möglich, einen Mikrochip aus der Messposition auslaufen zu lassen und währenddessen einen Mikrochip bis zum Zwischenstopper vorlaufen zu lassen. Durch den Zwischenstopper können der Bereich des Transportwegs bei der Messposition und stromab davon mechanisch von demjenigen Teil oberhalb des Zwischenstoppers getrennt werden, sodass beide Teile des Transportwegs gleichzeitig für die Bewegung von Mikrochips zur Verfügung stehen. Hiermit können deutlich erhöhte Durchsätze erreicht werden, im Vergleich zu dem Fall, dass zu einer bestimmten Zeit immer nur ein Mikrochip entlang des Transportwegs transportiert wird.

Der Zwischenstopper greift vorteilhafterweise möglichst dicht stromauf von der stromaufweisenden Kante des Mikrochips in der Messposition in den Transportweg ein. Er kann einen Mikrochip mit seiner stromabweisenden Kante beispielsweise maximal 1, 2, 3, 4 oder 5 Millimeter stromauf der stromaufweisenden Kante des Mikrochips in der Messposition stoppen.

Der Messstopper ist vorteilhafterweise so ausgeführt, dass er den Mikrochip an den elektrischen Kontakten stoppt. Die Mikrochips mit seitlich abstehenden elektrischen Kontakten (Beinchen), die auch Käfer oder SO-Mikrochips genannt werden, können gut an den Beinchen wohl positioniert gestoppt werden. Dadurch sind die elektrischen Kontakte an vorbestimmen Positionen, sodass die elektrischen Positionen zum elektrischen Testen der Mikrochips wohldefiniert sind.

Bei großen SO-Mikrochips kann es vorkommen, dass das Stoppen eines Mikrochips an einem elektrischen Kontakt zum Verbiegen des elektrischen Kontakts führt. In diesen Fällen ist es vorteilhaft, einen Mikrochipkörperstopper einzusetzen, der den Mikrochip etwas vor der Messposition an seinem Körper stoppt, sodass dann nur noch ein geringer Weg bis in die Messposition zurückgelegt werden muss, an der der Mikrochip dann ohne Verbiegungen an den elektrischen Kontakten gestoppt werden kann. Der Mikrochipkörperstopper definiert eine Position die zwischen der Zwischenposition und der Messposition liegt, wobei diese Position in der Regel mit der Messposition überlappt und evtl. auch mit der Zwischenposition überlappt.

Mit der Vorrichtung können jedoch auch sog. QFN-Mikrochips geprüft werden, bei denen die elektrischen Kontakte an einer Ober- oder Unterseite des Mikrochips gegeben sind, ohne seitlich herauszuragen. Diese Mikrochips werden dann jedoch nicht an elektrischen Kontakten, sondern an dem Körper gestoppt, der dann jedoch in Bezug auf die elektrischen Kontakte eine wohldefinierte vorgegebene feste geometrische Beziehung haben muss. Geeignete SO-Mikrochips können ebenfalls am Körper in der Messposition gestoppt werden. Falls die elektrischen Kontakte eines QFN-Mikrochips es zulassen, diesen daran zu stoppen und zwar so, dass der elektrische Kontakt noch in einfacher Weise zum Testen elektrisch kontaktiert werden kann, so können auch QFN-Mikrochips an den elektrischen Kontakten in der Messposition gestoppt werden.

Auch andere Mikrochiparten sind möglich, wie etwa MLP-, CSP- oder BGA- oder sonstige Mikrochips.

Vorteilhafterweise werden die Mikrochips entlang des Transportwegs durch Schwerkraft und/oder durch Beaufschlagung der Mikrochips mit Luft transportiert.

Stromab von der Messposition kann ein Nachstopper vorgesehen sein, mit dem ein aus der Messposition auslaufender Mikrochip in einer definierten Position gehalten werden kann. Nach dem elektrischen Testen der Mikrochips in der Messposition sollen die Mikrochips in verschiedene Behälter geführt werden, je nach ihren elektrischen Eigenschaften. Um hier die Weichenstellung oder die Führung in die entsprechenden Behälter vorzunehmen und einen Mikrochip dafür zu einem definierten Zeitpunkt freizugeben, ist ein solcher Nachstopper von Vorteil.

Stromab einer Messposition kann jedoch auch eine zweite und/oder dritte Messposition vorgesehen sein, an der dann ebenfalls jeweils ein Zwischenstopper, ein Messstopper und eventuell ein Mikrochipkörperstopper vorgesehen sind.

Stromab von dieser zweiten und/oder dritten Messposition kann eine weitere Messposition oder ein Nachstopper (siehe oben) vorgesehen sein.

Die Stopper können auf verschiedene Art und Weise realisiert werden. Üblich sind mechanische Stopper, die einen Mikrochip an ihrem Körper oder an den elektrischen Kontakten durch mechanischen Kontakt stoppen. Es sind jedoch auch Vakuumstopper bekannt, die einen Mikrochip auf einer Vakuumöffnung, beispielsweise mit seinem Körper festsaugen und ihn so festhalten.

Auch ist es möglich, mehrere Transportwege nebeneinander vorzusehen, um so höhere Durchsatzraten zu erhalten.

Es können Lichtschranken oder andere Positionssensoren eingesetzt werden, mit denen die Bewegung und/oder Positionierung der Mikrochips überwacht werden kann. Es kann beispielsweise geprüft werden, ob ein Mikrochip eine bestimmte Position zwischen der Vor-, der Zwischen-, der Mess-, oder der Nachposition durchschritten hat und/oder ob ein Mikrochip eine bestimmte Position wie etwa die Vor-, die Mess-, die Zwischen-, oder die Nachposition erreicht oder verlassen hat.

Bei dem Verfahren zum Positionieren von elektrischen Mikrochips zum elektrischen Testen werden ein erster Mikrochip in einer Messposition und ein zweiter Mikrochip in einer Vorposition gehalten. Anschließend werden die beiden Mikrochips bewegt, sodass sich einer aus der Messposition herausbewegt und der andere zur Messposition hinbewegt. Dies erfolgt so, dass beide Mikrochips zumindest teilweise gleichzeitig bewegt werden. Je größer der zeitliche Überlapp zwischen der Bewegung der beiden Mikrochips ist, desto höher ist die Durchsatzrate. Deshalb ist es vorteilhaft, jedoch nicht zwingend notwendig, die beiden Mikrochips gleichzeitig loszubewegen. Auch das Losbewegen der Mikrochips innerhalb eines Zeitintervalls von 0,5, 1, 2, 5, 10, 20, 30, 40, 50, 60, 70, 80, 90 oder 100 Millisekunden ist möglich. Das Bewegen kann beispielsweise durch das Loslassen durch einen Halter ausgelöst werden.

Vorteilhaft ist es weiterhin, wenn der eine Mikrochip unabhängig von der Bewegung eines andern Mikrochips losbewegt wird. Hier wird also nicht abgewartet bis ein Mikrochip eine bestimmte Position verlassen oder durchschritten hat (was z. B. mit einem Sensor wie einer Lichtschranke festsgestellt werden kann), um dies als Signal für das Auslösen der Bewegung des anderen Mikrochips zu verwenden, sondern die beiden Mikrochips werden unabhängig von einander losbewegt. Dieses Losbewegen gilt auch dann als unabhängig voneinander, wenn dies innerhalb eines vordefinierten Zeitintervalls geschieht.

Um zu verhindern, dass die beiden Mikrochips in einen Bereich stromab der Messposition gelangen, kann es vorteilhaft sein, einen Zwischenstopper vorzusehen, der einen Mikrochip in einer Position zwischen der Messposition und der Vorposition stoppt. Sobald ein Mikrochip die Messposition verlassen hat, kann ein Mikrochip in dieser Zwischenposition freigegeben werden, um dann durch den Messstopper gestoppt zu werden.

Weiterhin kann ein Verfahren zum Positionieren von elektrischen Mikrochips zum elektrischen Testen, das Halten eines ersten Mikrochips in einer Zwischenposition zwischen einer Messposition und einer Vorposition und das Halten eines zweiten Mikrochips in einer zweiten Zwischenposition oder einer Nachposition umfassen. Beide Mikrochips werden aus der jeweiligen Position wegbewegt. Hierbei bewegen sich beide Mikrochips zumindest zeitweise gleichzeitig, sodass eine Zeitersparnis auftritt. Auch hier kann das Bewegen der Mikrochips durch ein Loslassen aus einer Halterung erreicht werden. Die obigen Ausführungen zu Zeitintervall und unabhängigem Losbewegen gelten entsprechend.

Vorteilhafte Ausführungsformen sollen anhand der beiliegenden Figuren erläutert werden. Dabei zeigt:
- Figur 1: eine schematische Darstellung einer Vorrichtung zum Positionieren von elektrischen Mikrochips zum elektrischen Testen;
- Figur 2: verschiedene Ansichten eines Transportkopfes;
- Figur 3: eine schematische Darstellung der Verfahrensweise beim Positionieren von elektrischen Mikrochips zum elektrischen Testen; und
- Figur 4: eine schematische Darstellung der verschiedenen Verfahrenszustände beim Austausch von Mikrochips in zwei übereinanderliegenden Transportköpfen.

In den nachfolgenden Figuren ist exemplarisch der Fall des Testens von SO-Mikrochips aufgeführt, die eine dafür angepasste mechanische Führung benötigen. Andere Mikrochips wie etwa QFN-, MLP-, CSP- oder BGA-Mikrochips benötigen andere jeweils angepasste mechanische Führungen.

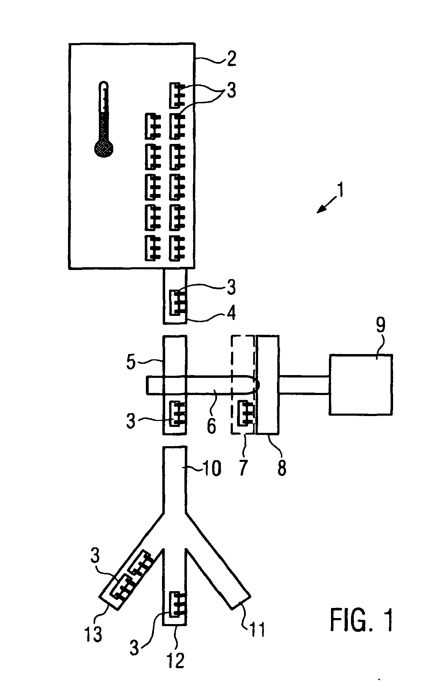

In Figur 1 ist eine Vorrichtung 1 zum Positionieren von elektrischen Mikrochips zum elektrischen Testen gezeigt. In einem Reservoir 2 werden elektrische Mikrochips 3 gespeichert. In diesem Reservoir können sie auf eine bestimmte Temperatur gebracht werden, um die Mikrochips anschließend bei dieser Temperatur testen zu können. Dies können sowohl gegenüber der Raumtemperatur erhöhte, als auch erniedrigte Temperaturen sein. Messungen ohne eine Temperierung der Mikrochips, also bei Raumtemperatur, sind ebenfalls möglich. Beispielsweise kann der Temperaturbereich von -60° bis +160° Celsius reichen.

Aus dem Speicher 2 werden die Mikrochips 3 entlang eines Transportwegs 4, 5, 10 abtransportiert. In dem Bereich 4 kann ein Mikrochip 3 gehalten werden. Der Bereich 5 ist ein Transportkopf, in den ein Mikrochip 3 eingesetzt werden kann, in dem er aus dem Abschnitt 4 in den Bereich des Transportkopfes 5 herunterfällt. Der Transportkopf 5 kann entlang von Achsen 6, Bolzen, Schienen oder Ähnlichem in Figur 1 nach rechts bewegt werden. Hierbei nimmt er einen Mikrochip 3 mit. Der Mikrochip 3 ist durch den Transportkopf 5 so gehalten, dass die elektrischen Kontakte nach rechts zeigend offen liegen. Mit dem Bezugszeichen 8 ist ein elektrischer Testkopf bezeichnet, der einen Mikrochip 3 in einem Transportkopf 5 elektrisch testen kann. Der elektrische Tester ist mit dem Bezugszeichen 9 versehen.

Nach dem Testen eines Mikrochips 3 in der rechtsliegenden Position des Transportkopfes 5 kann der Transportkopf wieder zurückgefahren, um den Mikrochip 3 so nach unten in den Bereich 10 ausgeben zu können und einen neuen Mikrochip 3 aus dem Bereich 4 aufnehmen zu können. Im unteren Bereich der Vorrichtung 1 sind schematisch verschiedene Behälter 11, 12 und 13 dargestellt, in die die verschiedenen Mikrochips je nach ihren elektrischen Eigenschaften, die sich beim Testen ergeben haben, einsortiert werden können. Entsprechende Weichen, mit denen die Mikrochips 3 in den einen oder anderen Behälter geleitet werden können, sind hier der Übersichtlichkeit halber nicht dargestellt. Aus dem Behälter 2 bis zu den Behältern 11, 12, 10 können sich die Mikrochips 3 allein durch ihre Schwerkraft bewegen. Es können jedoch auch Mittel vorgesehen sein, die Luft entlang der Abschnitte 4, 5 und 10 führt, um so die Bewegung der Mikrochips 3 zu beschleunigen.

Der Transportweg der Mikrochips 3 reicht in Fig. 1 beispielsweise von dem unteren Ende (in dem ein Mikrochip 3 gehalten werden kann) des Abschnitt 4, bis zu dem oberen Ende des Abschnitts 10. Auch in diesem oberen Ende kann ein Mikrochip eventuell gehalten werden.

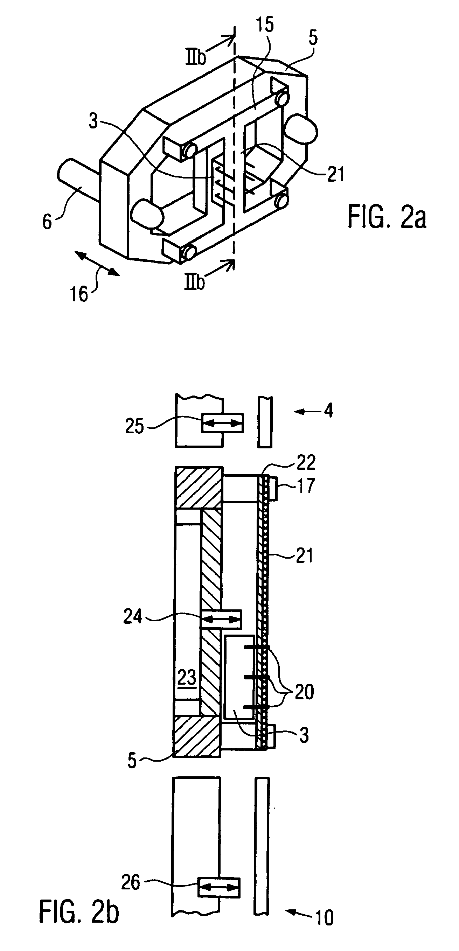

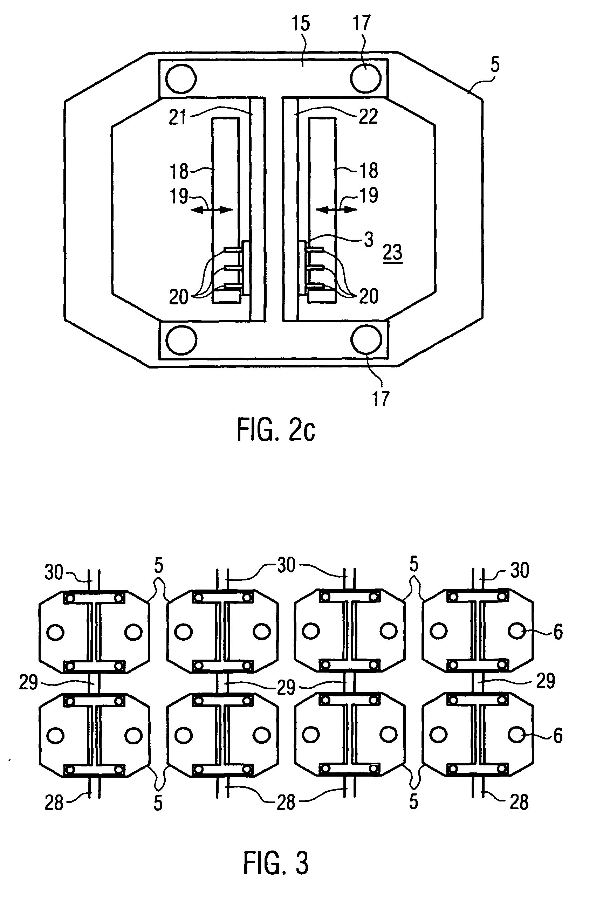

In Figur 2 a ist ein Transportkopf 5 in schematischer dreidimensionaler Ansicht dargestellt. Der Transportkopf 5 weist eine Grundplatte auf, auf der ein doppel-T-förmiges Bauteil 15 montiert ist. Dieses Bauteil hat einen Steg 21, hinter dem sich der Körper eines Mikrochips so anordnen lässt, dass die Beinchen oder elektrischen Kontakte des Mikrochips seitlich neben dem Steg 21 rechts und links herausschauen. Dies wird weiter unten noch näher erläutert werden. Der Transportkopf 5 kann in Richtung 16 vor- und zurückbewegt werden. Hierbei wird der Transportkopf 5 entlang der Bolzen 6 bewegt, auf denen er mit entsprechenden Gleithülsen oder Lagern gelagert ist.

Zum Antrieb des Transportkopfes 5 können elektrische, elektromechanische, pneumatische oder sonstige Betätigungsmittel vorgesehen sein. Diese sind hier jedoch der Übersichtlichkeit halber nicht dargestellt.

In Figur 2 b (Schnitt siehe Figur 2a) ist ein Transportkopf 5 in der zurückgefahrenen Position dargestellt. In Figur 2 b ist hierbei ein Teil des Transportweges für die Mikrochips gezeigt, der sich aus dem Abschnitt 4, dem Transportkopf 5 und dem Abschnitt 10 ergibt. Im Bereich des Abschnitts 4 ist ein Vorstopper 25 angeordnet. Dies kann ein Riegel oder Ähnliches sein, der den Transportweg der Mikrochips 3 versperren kann. Der Riegel 25 kann in Figur 2 b nach links und rechts beweglich sein, um so den Transportweg freizugeben oder zu versperren. Er kann aber auch senkrecht zur Zeichenebene bewegt werden, um den Transportweg freizugeben oder zu sperren. Auch eine Drehbewegung eines Riegels hierzu ist möglich. Der Vorstopper 25 ist so angeordnet, dass er am unteren Ende desjenigen Teils 4 des Transportwegs angeordnet ist, der stromauf von dem Transportkopf 5 liegt. Von dort aus kann ein Mikrochip 3 ohne großen Zeitverlust möglichst schnell in den Transportkopf 5 eingeführt werden.

In Figur 2 b ist der Steg 21 des doppel-T-förmigen Bauteils 15 dargestellt. An diesem Steg 21 ist ein Abstandshalter 22 angeordnet, der in der Regel aus einem elektrisch nichtleitenden Material gefertigt ist. Während das doppel-T-förmige Bauteil 15 in der Regel aus einem Metall gefertigt ist, wird durch den Abstandshalter 22 gewährleistet, dass die verschiedenen Beinchen 20 des Mikrochips 3 durch den Steg 21 keinen Kurzschluss erleiden.

In dem Transportkopf 5 ist ein Stopper 24 angeordnet, der oberhalb der Position des Mikrochips 3 angeordnet ist. Die in Figur 2 b dargestellte Position des Mikrochips 3 entspricht der Messposition. Der Stopper 24 ist also oberhalb der stromaufwärts (nach oben) weisenden Kante des Mikrochips 3 in der Messposition angeordnet. Der Stopper 24 kann auch hier beispielsweise ein Riegelelement sein, dass, wie in Figur 2 b dargestellt ist, nach links und rechts bewegt werden kann, um so den Transportweg freizugeben oder zu versperren. Auch kann ein Riegel vorgesehen sein, der senkrecht zur Zeichenebene bewegt wird, um so den Weg für die Mikrochips freizugeben oder zu versperren. Hierfür ist auch eine Drehbewegung eines Riegels ist möglich.

In dem Abschnitt 10 ist ein weiterer Stopper 26 vorgesehen, für den Entsprechendes gilt. Dies ist der Nachstopper, der zwischen der letzten Messposition entlang des Transportweges und den Weichen für die Verteilung der gemessenen Mikrochips in verschiedene Behälter vorgesehen ist.

Während der Zwischenstopper 24 mit dem Transportkopf 5 mitbeweglich ausgebildet ist, sind die Stopper 25 und 26 jeweils an dem feststehenden Abschnitt 4 und 10 angeordnet.

Der Transportkopf 5 kann auch eine Ausnehmung 23 aufweisen, um sein Gewicht zu reduzieren, um so eine schnellere Bewegung des Transportkopfes 5 zu ermöglichen.

Zum Halten eines Mikrochips 3 auf dem Transportweg ist eine Führung oder ähnliches vorgesehen, die verhindert, dass ein Mikrochip beispielsweise durch die Ausnehmung 23 herausfällt. Der Zwischenstopper 24 ist an oder bei einer solchen Führung angeordnet. Eine Führung verhindert auch ein seitliches Herausfallen oder Herauskippen eines Mikrochips aus dem Transportweg. Auch ein Verkanten wird möglichst verhindert. Die Führung kann sowohl an den Körper als auch an den elektrischen Kontakten angreifen.

In Figur 2 c ist noch einmal eine Draufsicht auf einen Transportkopf 5 gezeigt. Das doppel-T-förmige Bauteil 15 wird mit entsprechenden Halterungen 17, wie etwa Schrauben und Hülsen oder Ähnlichem, beabstandet von der Grundplatte des Transportkopfes 5, gehalten.

In Figur 2 c sind die Messstopper 18 zu erkennen. Dies sind längliche Elemente aus einem nichtleitenden Material entlang dem die Beinchen 20 eines Mikrochips 3 entlanggleiten können. Die Beinchen befinden sich jeweils zwischen den Messstoppem 18 und dem Abstandshalter 22 (siehe auch Figur 2 b). Die Messstopper 18 sind so ausgebildet, dass an ihrem unteren Ende eine Verdickung vorgesehen ist, mit der ein Beinchen 20 gehalten werden kann. Die Messstopper 18 sind hier somit geeignet, die elektrischen Kontakte des Mikrochips 3 vordefiniert zu positionieren. Die Messstopper 18 können in Richtung 19 hin und her bewegt oder geschwenkt werden, um den Transportweg freizugeben oder zu versperren. Bei der in Figur 2 c dargestellten Position wird der Transportweg dadurch versperrt, dass die Beinchen 20 von Mikrochips 3 mit dem unteren Ende der Messstopper 18 in Kontakt kommen, sodass der Weitertransport der Mikrochips 3 verhindert wird. Werden die Messstopper 18 in Richtung 19 nach außen bewegt, so wird der Transportweg für den Mikrochip 3 freigegeben, sodass er in Figur 2 c nach unten herausfallen kann.

Möglich sind Anordnungen von Transportköpfen 5 sowohl nebeneinander als auch übereinander. Ein Beispiel hierfür ist in Figur 3 gezeigt, in der acht Transportköpfe 5 vorgesehen sind, wobei vier nebeneinander und jeweils zwei übereinander angeordnet sind. Die Transportköpfe 5 übereinander sind durch entsprechende Transportwegstücke 29 miteinander verbunden. Oberhalb von dem jeweiligen obersten Transportkopf 5 befindet sich ein Abschnitt 30 (gleich Abschnitt 4 in Fig. 1 und 2b) des Transportwegs und unterhalb von dem untersten Transportkopf ein Abschnitt 28 (gleich Abschnitt 10 in Fig. 1 und 2b). Die verschiedenen Transportköpfe 5 können entweder alle einzeln oder auch gruppenweise, beispielsweise in zwei Gruppen zu vier Tischen oder vier Gruppen zu zwei Tischen, bewegt werden. Dies hat den Vorteil, dass bei Ausfall von einem Transportkopf einer Gruppe, beispielsweise durch Verklemmung eines Mikrochips, die andere Gruppe oder die anderen Gruppen von Transportköpfen weiter betrieben werden können.

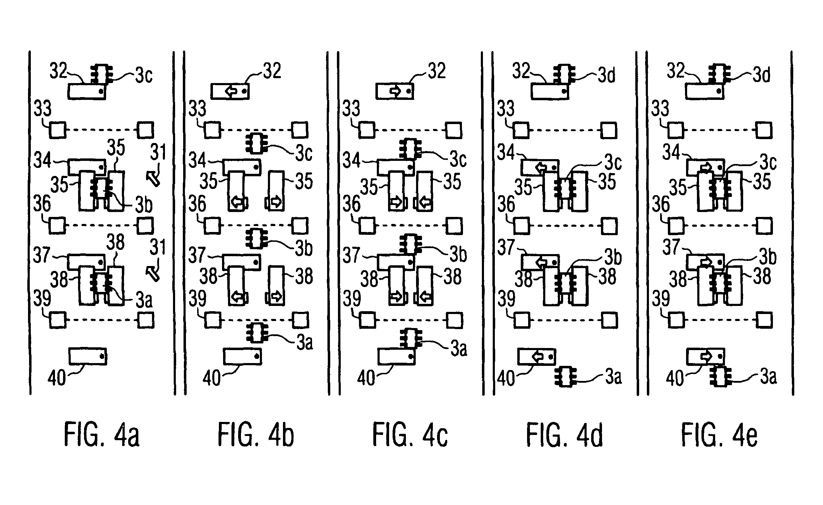

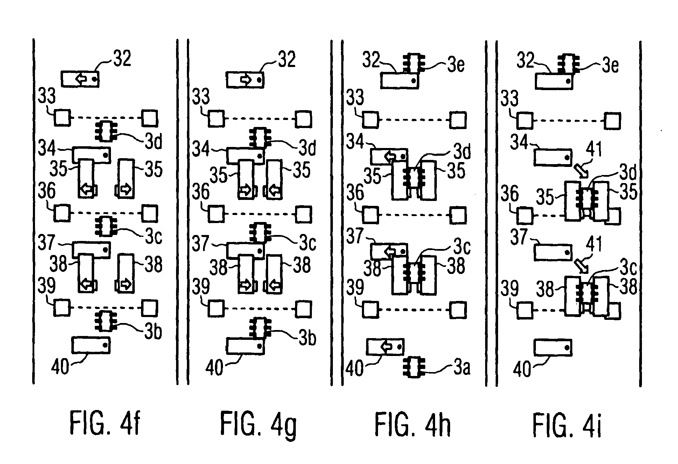

In Figur 4 ist ein Beispiel für die Vorgehensweise erläutert, bei der zwei Transportköpfe 5 übereinander angeordnet sind.

In dem Schritt 4a ist ein erster Mikrochip 3 a und darüber ein zweiter Mikrochip 3 b jeweils in zwei übereinanderliegenden Transportköpfen gehalten. Diese werden im Schritt 4a in Richtung 31 zurückgeschoben. Dies entspricht der Bewegung eines Transportkopfes 5 aus der Position 7 in Figur 1 in die Position links in Figur 1. Weiterhin ist ein dritter Mikrochip 3 c auf einem Vorstopper 32 entlang des Transportwegs gestoppt. Zwischenstopper 34 und 37 sind in ihrer geschlossenen Position, d. h. dass sie so positioniert sind, dass Mikrochips 3 die Stopper 34 und 37 nicht passieren können. Die Zwischenstopper 34 und 37 greifen hierbei also in den Transportweg oberhalb der in Figur 4 dargestellten Oberkanten der Mikrochips 3a und 3b ein.

Im Schritt 4b wird der dritte Mikrochip 3 c losgelassen und zwar dadurch, dass der Vorstopper 32 nach links aus der Transportbahn der Mikrochips 3 herausbewegt wird. Auch werden im Schritt b die Messstopper 35 und 38 geöffnet, sodass der zweite und erste Mikrochip 3 b und 3 a jeweils losgelassen werden.

Wie in Figur 4 c zu erkennen ist, läuft der erste Mikrochip 3 a hierbei zu dem Nachstopper 40, der zweite Mikrochip 3 b auf den Zwischenstopper 37 und der dritte Mikrochip 3 c auf den Zwischenstopper 34. Die Bewegung dieser drei Mikrochips erfolgt nahezu gleichzeitig. Bei der Bewegung der Mikrochips von der Vorstopper- oder Messstopperposition zu den Zwischenstoppem oder Nachstoppem durchlaufen die drei Mikrochips 3 a, 3 b und 3 c Lichtschranken 39, 36 und 33. Sobald diese Lichtschranken ein Dunkel- und anschließend wieder ein Hellsignal ergeben, ist sicher, dass alle drei Mikrochips aus ihrer Position in Figur 4 a losgelassen wurden und sich aus diesen jeweiligen Positionen weit genug wegbewegt haben. Dies ist jeweils das Signal zum jeweiligen Schließen des Vorstoppers 32 und der Messstopper 35 und 38 (siehe Figur 4 c).

Wie in Figur 4 d zu erkennen ist, wird dann ein vierter Mikrochip 3 d auf den Vorstopper 32 auflaufen gelassen. Dieser wird dort in einer Vorstopperposition bereitgehalten.

Wie in Figur 4 d weiter zu erkennen ist, werden die Zwischenstopper 34 und 37 sowie der Nachstopper 40 nun geöffnet, wobei jedoch die Messstopper 35 und 38 geschlossen sind (siehe in Figur 4 c). Durch das Öffnen der Zwischenstopper 34 und 37 können die zweiten und dritten Mikrochips 3 b und 3 c in die jeweilige Messposition gelangen und werden dort durch die Messstopper 35 und 38 gestoppt. Durch das Öffnen des Nachstoppers 40 wird der erste Mikrochip 3 a nach unten ausgegeben und kann in den entsprechenden Sortierbehälter geführt werden. Nach Abwarten einer gewissen Zeit werden die Zwischenstopper 34 und 37 und der Nachstopper 40 wieder geschlossen (siehe Figur 4 e).

In Figur 4 f ist dargestellt, dass dann erneut der Vorstopper 32 und die Messstopper 35 und 38 geöffnet werden. Hierbei durchlaufen die Mikrochips 3 b, 3 c und 3 d erneut die Lichtschranken 33, 36 und 39, wobei hier dann abgewartet wird, bis diese Lichtschranken nach einem Dunkel- wieder ein Hellsignal geben. Dies ist das Zeichen dafür, dass die Mikrochips aus den jeweiligen Positionen (siehe Figur 4 e) losgelassen wurden und sich weit genug fortbewegt haben.

Wie in Figur 4 g zu erkennen ist, laufen die Mikrochips 3 b, 3 c und 3 d dann auf den Nachstopper 40 bzw. die Zwischenstopper 37 und 34. Die Messstopper 35 und 38 und der Vorstopper 32 können dann geschlossen werden. Nachdem diese geschlossen sind, werden die Zwischenstopper 34, 37 und der Nachstopper 40 wieder geöffnet, sodass die jeweiligen Mikrochips freigegeben werden, d. h. dass der dritte Mikrochip 3 c in die zweite Messposition und der vierte Mikrochip 3 d in die obere Messposition einlaufen können und dort von den Messstoppem 35 und 38 gestoppt werden. Währenddessen ist auch ein fünfter Mikrochip 3 e eingelaufen, der auf dem Vorstopper 32 in einer Vorstopperposition bereitsteht.

Mit diesen Verfahrensschritten wurden die Mikrochips 3 a und 3 b (siehe Figur 4 a) gegen die Mikrochips 3 c und 3 d in den jeweilige Messposition ausgetauscht. Die zugehörigen Transportköpfe 5 können dann in Richtung 41 ausgefahren werden, um die Mikrochips 3 c und 3 d mit dem elektrischen Messkopf 8 (siehe Figur 1) in Kontakt zu bringen.

Statt der Lichtschranken 33, 36 und 39 können auch bestimmte Zeitintervalle gewartet werden, in denen davon auszugehen ist, dass die jeweiligen Mikrochips 3 die gewünschte Position erreicht haben. Auch können noch mehr Lichtschranken vorgesehen sein, um den jeweiligen Weitertransport der Mikrochips 3 zu kontrollieren. Hier kann beispielsweise eine Lichtschranke eingesetzt werden, um zu prüfen, dass der Mikrochip 3 b (siehe Figur 4 c und 4d) von der Zwischenstopperposition durch den Zwischenstopper 37 losgelassen wurde und/oder sich in Richtung zu der Messposition zwischen den beiden Messstoppem 38 bewegt hat. Die hierbei gewonnenen Signale können zur Auslösung des jeweilig nachfolgenden Schritts herangezogen werden.

Ein Verfahren, wie es in Figur 4 dargestellt ist, kann in etwa einer halben Sekunde durchgeführt werden. Damit sind somit relativ hohe Durchsatzraten erreichbar.

In Figur 4 ist der Fall dargestellt, dass zwei Messpositionen übereinander angeordnet sind.

## Patentansprüche

1. Vorrichtung (1) zum Positionieren von elektronischen Mikrochips (3) zum elektrischen Testen mit:
einem Transportweg (4, 5, 10) für die Mikrochips (3), der eine Messposition umfasst und mit
einem Messstopper (18, 35, 38), mit dem ein Mikrochip (3) entlang des Transportwegs (4, 5, 10) in der Messposition gehalten werden kann und mit
einem Vorstopper (25, 32), mit dem ein Mikrochip (3) in einer Position stromauf von der Messposition in einer Vorstopperposition gehalten werden kann und mit
einen Zwischenstopper (24, 34, 37), mit dem einen Mikrochip (3) in einer Position zwischen der Messposition und der Vorstopperposition gehalten werden kann
wobei der Zwischenstopper (24, 34, 37) in den Transportweg in einem Bereich stromauf der stromaufwärts weisenden Kante des Mikrochips (3) in der Messposition eingreift,
**dadurch gekennzeichnet, dass**
stromab der Messposition ein zweiter Zwischenstopper (37) und ein zweiter Messstopper (38) an einer zweiten Messposition vorgesehen sind.

2. Vorrichtung nach Anspruch 1, **dadurch gekennzeichnet, dass** der erste Messstopper (18, 35, 38) einen Mikrochip (3) an den elektrischen Kontakten (20) oder an seinem Körper hält.

3. Vorrichtung nach Anspruch 1 oder 2, **dadurch gekennzeichnet, dass** ein Mikrochipkörperstopper vorgesehen ist, mit dem ein Mikrochip (3) an seinem Körper in einer Position zwischen der durch den ersten Zwischenstopper definierten Zwischenposition und der Messposition gestoppt werden kann und vorzugsweise ein zweiter Mikrochipkörperstopper vorgesehen ist.

4. Vorrichtung nach einem der Ansprüche 1 bis 3, **dadurch gekennzeichnet, dass** die Mikrochips (3) entlang des Transportwegs (4, 5, 10) durch Schwerkraft und/oder bewegte Luft transportiert werden.

5. Vorrichtung nach einem der Ansprüche 1 bis 4, **dadurch gekennzeichnet, dass** stromab von der zweiten Messposition ein Nachstopper (40) vorgesehen ist.

6. Vorrichtung nach einem der Ansprüche 1 bis 5, **dadurch gekennzeichnet, dass** einer, zwei, drei oder noch mehr der Stopper einen mechanischen Stopper umfassen.

7. Vorrichtung nach einem der Ansprüche 1 bis 6, **dadurch gekennzeichnet, dass** einer, zwei oder drei oder noch mehr der Stopper einen Vakuumstopper umfassen.

8. Vorrichtung nach einem der Ansprüche 1 bis 7, **dadurch gekennzeichnet, dass** mehrere Transportwege (28, 29, 30) mit den entsprechenden Stoppern und Messpositionen parallel nebeneinander vorgesehen sind.

9. Verfahren zum Positionieren von elektronischen Mikrochips (3) zum elektrischen Testen mit den Schritten:
Halten eines ersten Mikrochips (3b) in einer Messposition und Halten eines zweiten Mikrochips (3c) in einer Vorposition,
Wegbewegen des ersten Mikrochips (3b) aus der Messposition und Hinbewegen des zweiten Mikrochips (3c) zu der Messposition,
wobei sich beide Mikrochips (3b, 3c) zumindest zeitweise gleichzeitig bewegen,
**dadurch gekennzeichnet, dass**
der zweite Mikrochip von einem Zwischenstopper (34) in einer Zwischenposition gestoppt wird, wobei die Zwischenposition zwischen der Vorposition und der Messposition liegt und keinen Überlapp mit der Messposition hat und,
dass der zweite Mikrochip (3c) nach dem Stoppen durch den Zwischenstopper (34) in die Messposition bewegt wird, wo er gehalten wird, und,
dass der zweite Mikrochip (3c) nach dem Halten in der Messposition von dort wegbewegt wird und von einem Zwischenstopper (37) einer zweiten Messposition (40) gestoppt wird.

10. Verfahren nach Anspruch 9, **dadurch gekennzeichnet, dass** der erste bzw. der zweite Mikrochip (3b, 3c) gleichzeitig oder in einem Zeitintervall von nicht mehr als 0,5, 1, 2, 5, 10, 20, 30, 40, 50, 60, 70, 80, 90 oder 100 Millisekunden aus der Messposition bzw. zur Messposition losbewegt werden, beispielsweise durch loslassen.

11. Verfahren nach einem der Ansprüche 9 oder 10, **dadurch gekennzeichnet, dass** die Bewegung des zweiten Mikrochips unabhängig von der Bewegung des ersten Mikrochips ausgelöst wird, beispielsweise durch loslassen.

12. Verfahren nach einem der Ansprüche 9 bis 11, **dadurch gekennzeichnet, dass** der erste Mikrochip (3b) von einem zweiten Zwischenstopper (37) einer zweiten Messposition oder von einem Nachstopper (40) gestoppt wird.

13. Verfahren nach Anspruch 12, **dadurch gekennzeichnet, dass** sich der zweite Mikrochip (3c) nach dem Wegbewegen aus der Zwischenstopperposition und der erste Mikrochip (3b) nach dem Wegbewegen aus der zweiten Zwischenstopperposition oder einer Nachstopperposition zumindest teilweise gleichzeitig bewegen, wobei Sie vorzugsweise in etwa gleichzeitig losbewegt werden.

14. Verfahren zum Positionieren von elektronischen Mikrochips (3) zum elektrischen Testen mit den Schritten:
Halten eines ersten Mikrochips (3b) in einer Zwischenposition zwischen einer Messposition und einer Vorposition, wobei die Zwischenposition keinen Überlapp mit der Messposition hat, und Halten eines zweiten Mikrochips (3c) in einer zweiten Zwischenposition einer zweiten Messposition,
Wegbewegen des ersten Mikrochips (3b) aus der Zwischenposition und
Wegbewegen des zweiten Mikrochips (3c) aus der zweiten Zwischenposition,
**dadurch gekennzeichnet, dass**
sich beide Mikrochips (3b, 3c) zumindest zeitweise gleichzeitig bewegen.

15. Verfahren nach Anspruch 14, **dadurch gekennzeichnet, dass** der erste und der zweite Mikrochip (3b, 3c) gleichzeitig oder in einem Zeitintervall von nicht mehr als 0,5 1, 2, 5, 10, 20, 30, 40, 50, 60, 70, 80, 90 oder 100 Millisekunden losbewegt werden, beispielsweise durch loslassen.

16. Verfahren nach einem der Ansprüche 14 oder 15, **dadurch gekennzeichnet, dass** die Bewegung des ersten Mikrochips (3b) unabhängig von der Bewegung des zweiten Mikrochips (3c) ausgelöst wird, beispielsweise durch loslassen.

## Claims

1. Device (1) for positioning electronic microchips (3) for electrical testing, comprising:
a transport path (4, 5, 10) for the microchips (3) containing a measuring position and
a measurement stopping device (18, 35, 38) by means of which a microchip (3) can be held in the measuring position along the transport path (4, 5, 10) and
an initial stopping device (25, 32) by means of which a microchip (3) can be held in an initial stopping device position in a position upstream of the measuring position and
an intermediate stopping device (24, 34, 37) by means of which a microchip (3) can be held in a position between the measuring position and the initial stopping device position,
the intermediate stopping device (24, 34, 37) engaging in the transport path in the measuring position in a region upstream of the edge of the microchip (3) pointing upstream,
**characterised in that**
a second intermediate stopping device (37) is disposed downstream of the measuring position and a second measurement stopping device (38) is provided at a second measuring position.

2. Device as claimed in claim 1, **characterised in that** the first measurement stopping device (18, 35, 38) holds a microchip (3) by the electrical contacts (20) or by its body.

3. Device as claimed in claim 1 or 2, **characterised in that** a microchip body stopping device is provided, by means of which a microchip (3) can be stopped by its body in a position between the intermediate position defined by the first intermediate stopping device and the measuring position, and a second microchip body stopping device is preferably provided.

4. Device as claimed in one of claims 1 to 3, **characterised in that** the microchips (3) are conveyed along the transport path (4, 5, 10) by force of gravity and/or moved air.

5. Device as claimed in one of claims 1 to 4, **characterised in that** a downstream stopping device (40) is provided downstream of the second measuring position.

6. Device as claimed in one of claims 1 to 5, **characterised in that** one, two, three or more of the stopping devices have a mechanical stopping device.

7. Device as claimed in one of claims 1 to 6, **characterised in that** one, two or three or more of the stopping devices have a vacuum stopping device.

8. Device as claimed in one of claims 1 to 7, **characterised in that** several transport paths (28, 29, 30) incorporating the appropriate stopping devices and measuring positions are disposed parallel with one another.

9. Method of positioning electronic microchips (3) for electrical testing, comprising the steps of:
holding a first microchip (3b) in a measuring position and holding a second microchip (3c) in an initial position,
moving the first microchip (3b) away from the measuring position and moving the second microchip (3c) to the measuring position,
the two microchips (3b, 3c) being moved simultaneously at least some of the time,
**characterised in that**
the second microchip is stopped in an intermediate position by an intermediate stopping device (34) and the intermediate position lies between the initial position and the measuring position and does not overlap with the measuring position, and
having been stopped by the intermediate stopping device (34), the second microchip (3c) is moved into the measuring position, where it is held, and having been held in the measuring position, the second microchip (3c) is moved away from it and is stopped in a second measuring position (40) by an intermediate stopping device (37).

10. Method as claimed in claim 9, **characterised in that** the first respectively the second microchip (3b, 3c) are moved away from the measuring position respectively to the measuring position, for example by a releasing action, simultaneously or at a time interval of not more than 0.5, 1, 2, 5, 10, 20, 30, 40, 50, 60, 70, 80, 90 or 100 milliseconds.

11. Method as claimed in one of claims 9 or 10, **characterised in that** the movement of the second microchip is initiated independently of the movement of the first microchip, for example by a releasing action.

12. Method as claimed in one of claims 9 to 11, **characterised in that** the first microchip (3b) is stopped by a second intermediate stopping device (37) of a second measuring position or by a downstream stopping device (40).

13. Method as claimed in claim 12, **characterised in that** the second microchip (3c), having been moved away from the intermediate stopping device position, and the first microchip (3b), having been moved away from the second intermediate stopping device position or a downstream stopping device position, are moved at least partially simultaneously, and they are preferably moved off approximately simultaneously.

14. Method of positioning electronic microchips (3) for electrical testing, comprising the steps of:
holding a first microchip (3b) in an intermediate position between a measuring position and an initial position, whereby the intermediate position does not overlap with the measuring position, and holding a second microchip (3c) in a second intermediate position of a second measuring position,
moving the first microchip (3b) away from the intermediate position and
moving the second microchip (3c) away from the second intermediate position,
**characterised in that**
the two microchips (3b, 3c) move simultaneously at least part of the time.

15. Method as claimed in claim 14, **characterised in that** the first and the second microchip (3b, 3c) are moved off, for example by a releasing action, simultaneously or at a time interval of not more than 0.5, 1, 2, 5, 10, 20, 30, 40, 50, 60, 70, 80, 90 or 100 milliseconds.

16. Method as claimed in one of claims 14 or 15, **characterised in that** the movement of the first microchip (3b) is initiated independently of the movement of the second microchip (3c), for example by a releasing action.

## Revendications

1. Dispositif (1) pour positionner des micropuces électroniques (3) en vue d'un test électrique, avec
une trajectoire de transport (4, 5, 10) pour les micropuces (3), qui comprend une position de mesure, et avec
un élément d'arrêt de mesure (18, 35, 38) à l'aide duquel une micropuce (3) peut être arrêtée dans la position de mesure, le long de la trajectoire de transport (4, 5, 10), et avec
un élément d'arrêt amont (25, 32) à l'aide duquel une micropuce (3) peut être arrêtée en amont de la position de mesure, dans une position d'élément d'arrêt amont, et avec
un élément d'arrêt intermédiaire (24, 34, 37) à l'aide duquel une micropuce (3) peut être arrêtée dans une position entre la position de mesure et la position d'élément d'arrêt amont,
l'élément d'arrêt intermédiaire (24, 34, 37) entrant dans la trajectoire de transport dans une zone située en amont du bord de la micropuce (3) dirigé côté amont, dans la position de mesure,
**caractérisé en ce qu'**il est prévu, en aval de la position de mesure, un second élément d'arrêt intermédiaire (37) et un second élément d'arrêt de mesure (38) au niveau d'une seconde position de mesure.

2. Dispositif selon la revendication 1, **caractérisé en ce que** le premier élément d'arrêt de mesure (18, 35, 38) arrête une micropuce (3) au niveau des contacts électriques (20) ou au niveau de son corps.

3. Dispositif selon la revendication 1 ou 2, **caractérisé en ce qu'**il est prévu un élément d'arrêt de corps de micropuce à l'aide duquel une micropuce (3) peut être arrêtée au niveau de son corps dans une position située entre la position intermédiaire définie par le premier élément d'arrêt intermédiaire, et la position de mesure, et il est prévu de préférence un second élément d'arrêt de corps de micropuce.

4. Dispositif selon l'une des revendications 1 à 3, **caractérisé en ce que** les micropuces (3) sont transportées le long de la trajectoire de transport (4, 5, 10) par gravité et/ou grâce à de l'air déplacé.

5. Dispositif selon l'une des revendications 1 à 4, **caractérisé en ce qu'**un élément d'arrêt aval (40) est prévu en aval de la seconde position de mesure.

6. Dispositif selon l'une des revendications 1 à 5, **caractérisé en ce qu'**un, deux, trois éléments d'arrêt ou plus comprennent un élément d'arrêt mécanique.

7. Dispositif selon l'une des revendications 1 à 6, **caractérisé en ce qu'**un, deux, trois éléments d'arrêt ou plus comprennent un élément d'arrêt à vide.

8. Dispositif selon l'une des revendications 1 à 7, **caractérisé en ce que** plusieurs trajectoires de transport (28, 29, 30) avec les éléments d'arrêt et les positions de mesure correspondants sont prévues côte à côte, parallèlement.

9. Procédé pour positionner des micropuces électroniques (3) en vue d'un test électrique, avec les étapes qui consistent :
à arrêter une première micropuce (3b) dans une position de mesure et à arrêter une seconde micropuce (3c) dans une position amont,
à éloigner la première micropuce (3b) de la position de mesure et à diriger la seconde micropuce (3c) vers la position de mesure,
les deux micropuces (3b, 3c) se déplaçant au moins temporairement en même temps,
**caractérisé en ce que** la seconde micropuce est arrêtée par un élément d'arrêt intermédiaire (34) dans une position intermédiaire, cette position intermédiaire étant située entre la position amont et la position de mesure et ne chevauchant pas la position de mesure, et
**en ce que** la seconde micropuce (3c), après avoir été arrêtée par l'élément d'arrêt intermédiaire (34), est déplacée jusqu'à la position de mesure, où elle est arrêtée, et
**en ce que** la seconde micropuce (3c), après avoir été arrêtée dans la position de mesure, est déplacée à partir de là et est arrêtée par un élément d'arrêt intermédiaire (37) d'une seconde position de mesure (40).

10. Procédé selon la revendication 9, **caractérisé en ce que** les première et seconde micropuces (3b, 3c) sont déplacées à partir de la position de mesure ou jusqu'à celle-ci, par exemple en étant relâchées, en même temps ou à un intervalle qui ne dépasse pas 0,5, 1, 2, 5, 10, 20, 30, 40, 50, 60, 70, 80, 90 ou 100 millisecondes.

11. Procédé selon l'une des revendications 9 à 10, **caractérisé en ce que** le déplacement de la seconde micropuce est déclenché, par exemple grâce à un relâchement, indépendamment du déplacement de la première micropuce.

12. Procédé selon l'une des revendications 9 à 11, **caractérisé en ce que** la première micropuce (3b) est arrêtée par un second élément d'arrêt intermédiaire (37) d'une seconde position de mesure ou par un élément d'arrêt aval (40).

13. Procédé selon la revendication 12, **caractérisé en ce que** la seconde micropuce (3c), après son déplacement à partir de la position d'élément d'arrêt intermédiaire, et la première micropuce (3b), après son déplacement à partir de la seconde position d'élément d'arrêt intermédiaire ou d'une position d'élément d'arrêt aval, se déplacent au moins temporairement en même temps, étant précisé qu'elles sont relâchées de préférence à peu près en même temps.

14. Procédé pour positionner des micropuces électroniques (3) en vue d'un test électrique, avec les étapes qui consistent :
à arrêter une première micropuce (3b) dans une position intermédiaire entre une position de mesure et une position amont, la position intermédiaire ne présentant pas de chevauchement avec la position de mesure, et à arrêter une seconde micropuce (3c) dans une seconde position intermédiaire d'une seconde position de mesure,
à éloigner la première micropuce (3b) de la position intermédiaire,
à éloigner la seconde puce (3c) de la seconde position intermédiaire,
**caractérisé en ce que** les deux micropuces (3b, 3c) se déplacent au moins temporairement en même temps.

15. Procédé selon la revendication 14, **caractérisé en ce que** les première et seconde micropuces (3b, 3c) sont déplacées à partir de la position de mesure ou jusqu'à celle-ci, par exemple en étant relâchées, en même temps ou à un intervalle qui ne dépasse pas 0,5, 1, 2, 5, 10, 20, 30, 40, 50, 60, 70, 80, 90 ou 100 millisecondes.

16. Procédé selon l'une des revendications 14 ou 15, **caractérisé en ce que** le déplacement de la première micropuce (3b) est déclenché, par exemple grâce à un relâchement, indépendamment du déplacement de la seconde micropuce (3c).
